# EUROPEAN PATENT APPLICATION

(11) **EP 4 751 977 A1**
(43) Date of publication of application: **03.06.2026**
(21) Application number: 25209043.6
(22) Date of filing: 16.10.2025
(51) Int. Cl.: B60L 3/12, B60L 58/21, G01R 31/3835, G01R 31/396, H01M 10/48

(54) **BATTERY PACK, METHOD FOR MONITORING A BATTERY PACK**

(30) Priority: 14.11.2024 CN 202411624504; 26.08.2025 CN 202511205934
(71) Applicant: Nanjing Chervon Industry Co., Ltd., Nanjing, Jiangsu 211106 (CN)
(72) Inventor: ZHAO, Chenyan, Nanjing, Jiangsu 211106 (CN); HUANG, Cunrong, Nanjing, Jiangsu 211106 (CN); WU, Di, Nanjing, Jiangsu 211106 (CN)
(74) Representative: Sun, Yiming

(57) **Abstract**

A battery pack includes a housing; a cell assembly including n cell units connected in series; a sampling circuit including n sampling terminals connected to the n cell units in one-to-one correspondence; and a processor electrically connected to the sampling circuit and used for monitoring the state of the cell assembly. The processor is configured to, when receiving a sampling instruction, sample the n sampling terminals to acquire pieces of sampling data and determine the voltages of the n cell units or the voltage of the battery pack based on the pieces of sampling data. The sampling time interval t1 between two adjacent samplings has a value range of 10µs ≤ t1 ≤ 50µs.

## Description

### TECHNICAL FIELD

The present application relates to the technical field of tool devices and, in particular, to a battery pack, a method for monitoring a battery pack, and a charging system.

### BACKGROUND

The most basic and important function of the battery management system is to collect high-accuracy voltage, current, and temperature parameters. The accuracy of the collected voltage is crucial to the control accuracy of the battery pack.

In the related art, a method for monitoring the voltage of each cell unit in a battery pack is to sample sampling terminals in sequence and calculate the voltage until all the sampling terminals have been sampled. After sampling, the voltage of the current cell unit is calculated in real time, and then the next sampling terminal is sampled until all the sampling terminals have been sampled, thereby completing a sampling cycle. In this case, the sampling cycle is too long and the voltages of all the cell units cannot be collected synchronously. Due to the periodic change of voltage, when the sampling cycle is too long, the error in the calculated voltage is larger, resulting in low accuracy of the collected voltage, affecting the accuracy of the calculated state of charge and state of power, as well as the charging and discharging efficiency and safety performance of the battery pack.

This part provides background information related to the present application, and the background information is not necessarily the existing art.

### SUMMARY

An object of the present application is to solve or at least alleviate part or all of the preceding problems. Therefore, an object of the present application is to provide a battery pack, a method for monitoring a battery pack, and a charging system, thereby solving the problems existing in the existing art, improving the accuracy of the collected voltage of each cell unit, improving the accuracy of the calculated state of charge and state of power, and improving the charging and discharging efficiency and safety performance of the battery pack.

To achieve the preceding object, the present application adopts the technical solutions below.

In a first aspect, the present application provides a battery pack. The battery pack includes a housing, a cell assembly, a sampling circuit, and a processor. The cell assembly is disposed within the housing and includes n cell units connected in series, where n > 1, and n is an integer. The sampling circuit includes n sampling terminals connected to the cell units in one-to-one correspondence. The processor is electrically connected to the sampling circuit and used for monitoring the state of the cell assembly. The processor is configured to, when receiving a sampling instruction, sample the n sampling terminals to acquire pieces of sampling data and determine the voltages of the cell units or the voltage of the battery pack based on the pieces of sampling data, where the sampling time interval t1 between two adjacent samplings has a value range of 10µs ≤ t1 ≤ 50µs.

In a second aspect, the present application provides a method for monitoring a voltage of each cell unit in a battery pack. The battery pack includes a cell assembly, a sampling circuit, and a processor; the cell assembly includes n cell units connected in series; the sampling circuit includes n sampling terminals in one-to-one correspondence with the cell units; the processor is used for monitoring the state of the cell assembly; and the method includes the steps below. When a sampling instruction is received, pieces of sampling data of the sampling terminals are acquired. Based on the pieces of sampling data, the voltages of the cell units are determined or the voltage of the battery pack is determined.

In a third aspect, the present application provides a charging system. The charging system includes a battery pack, at least one of a charger or a power tool, and a battery management module. The battery pack is used for receiving or outputting electrical energy and includes n cell units connected in series and a sampling circuit, where the sampling circuit includes n sampling terminals in one-to-one correspondence with the cell units. The charger is used for supplying electrical energy to the battery pack, and the power tool is used for receiving electrical energy outputted by the battery pack. The battery management module is used for monitoring the state of the battery pack. The battery management module is configured to acquire pieces of sampling data from all the sampling terminals and determine the voltages of the cell units and the voltage of the battery pack based on all the pieces of sampling data.

In a fourth aspect, the present application provides a battery pack. The battery pack includes a housing, a cell assembly, a sampling circuit, and a processor. The cell assembly is disposed within the housing and includes n cell units, where the n cell units are a first cell unit, a second cell unit, ..., and an n-th cell unit that are connected in series in sequence. The sampling circuit includes n sampling terminals, where a sampling terminal electrically connected to the first cell unit is a first sampling terminal, a sampling terminal electrically connected to the second cell unit is a second sampling terminal, ..., and a sampling terminal electrically connected to the n-th cell unit is an n-th sampling terminal. The processor is electrically connected to the sampling circuit and used for monitoring the state of the cell assembly. The processor is configured to, in a fault detection mode, sample the n sampling terminals to acquire pieces of sampling data of the sampling terminals and determine the working state of the sampling circuit based on the pieces of sampling data. The fault detection mode includes a first detection sub-mode and a second detection sub-mode; in the first detection sub-mode, even-numbered sampling terminals are enabled and odd-numbered sampling terminals are disabled; in the second detection sub-mode, the odd-numbered sampling terminals are enabled and the even-numbered sampling terminals are disabled; and the working state includes at least a fault state and a normal state.

In a fifth aspect, the present application provides a method for identifying a fault of a battery pack. The battery pack includes a cell assembly, a sampling circuit, and a processor; the cell assembly includes n cell units connected in series; the sampling circuit includes n sampling terminals in one-to-one correspondence with the cell units; the processor is used for monitoring the state of the cell assembly; and the method includes the steps below. In a fault detection mode, the processor controls some sampling terminals to be enabled and samples the sampling terminals to acquire pieces of sampling data of the sampling terminals. The working state of the sampling circuit is determined based on the pieces of sampling data, where the working state includes at least a fault state and a normal state.

The benefit of the present application is described below. The cell assembly includes n cell units connected in series, and the sampling terminals of the sampling circuit are connected to the cell units in one-to-one correspondence so that each sampling terminal can collect sampling data of the corresponding cell unit. The processor of the battery pack is configured to, when receiving the sampling instruction, sample the n sampling terminals to acquire pieces of sampling data and determine the voltages of the cell units or the voltage of the battery pack based on the pieces of sampling data. After the pieces of sampling data are collected, the pieces of sampling data are processed to obtain the voltages of the cell units so that the sampling time interval t1 between two adjacent samplings can satisfy 10µs ≤ t1 ≤ 50µs. In this manner, the sampling time of the sampling terminals can be greatly shortened, and the error value of the determined voltage is smaller, which is conducive to improving the accuracy of the collected voltage of each cell unit, thereby improving the accuracy of the calculated state of charge and state of power and improving the charging and discharging efficiency and safety performance of the battery pack.

### BRIEF DESCRIPTION OF THE DRAWINGS

To illustrate technical solutions in examples of the present application more clearly, the drawings used in the description of the examples are briefly described below. Apparently, the drawings described below illustrate only part of the examples of the present application, and those of ordinary skill in the art may obtain other drawings based on the drawings described below on the premise that no creative work is done.
FIG. 1 is a schematic view of power tools and a battery pack according to an example of the present application.
FIG. 2 is a schematic block diagram of a battery pack according to an example of the present application.
FIG. 3 is a partial circuit diagram of a battery pack according to an example of the present application.
FIG. 4 is a flowchart of a method for monitoring the voltage of each cell unit in a battery pack according to an example of the present application.
FIG. 5 is a comparison diagram of voltage sampling data according to an example of the present application.
FIG. 6 is a flowchart of a method for identifying a fault of a battery pack according to an example of the present application.

### DETAILED DESCRIPTION

Before any examples of this application are explained in detail, it is to be understood that this application is not limited to its application to the structural details and the arrangement of components set forth in the following description or illustrated in the above drawings.

In this application, the terms "comprising", "including", "having" or any other variation thereof are intended to cover an inclusive inclusion such that a process, method, article or device comprising a series of elements includes not only those series of elements, but also other elements not expressly listed, or elements inherent in the process, method, article, or device. Without further limitations, an element defined by the phrase "comprising a ..." does not preclude the presence of additional identical elements in the process, method, article, or device comprising that element.

In this application, the term "and/or" is a kind of association relationship describing the relationship between associated objects, which means that there can be three kinds of relationships. For example, A and/or B can indicate that A exists alone, A and B exist simultaneously, and B exists alone. In addition, the character "/" in this application generally indicates that the contextual associated objects belong to an "and/or" relationship.

In this application, the terms "connection", "combination", "coupling" and "installation" may be direct connection, combination, coupling or installation, and may also be indirect connection, combination, coupling or installation. Among them, for example, direct connection means that two members or assemblies are connected together without intermediaries, and indirect connection means that two members or assemblies are respectively connected with at least one intermediate members and the two members or assemblies are connected by the at least one intermediate members. In addition, "connection" and "coupling" are not limited to physical or mechanical connections or couplings, and may include electrical connections or couplings.

In this application, it is to be understood by those skilled in the art that a relative term (such as "about", "approximately", and "substantially") used in conjunction with quantity or condition includes a stated value and has a meaning dictated by the context. For example, the relative term includes at least a degree of error associated with the measurement of a particular value, a tolerance caused by manufacturing, assembly, and use associated with the particular value, and the like. Such relative term should also be considered as disclosing the range defined by the absolute values of the two endpoints. The relative term may refer to plus or minus of a certain percentage (such as 1%, 5%, 10%, or more) of an indicated value. A value that did not use the relative term should also be disclosed as a particular value with a tolerance. In addition, "substantially" when expressing a relative angular position relationship (for example, substantially parallel, substantially perpendicular), may refer to adding or subtracting a certain degree (such as 1 degree, 5 degrees, 10 degrees or more) to the indicated angle.

In this application, those skilled in the art will understand that a function performed by an assembly may be performed by one assembly, multiple assemblies, one member, or multiple members. Likewise, a function performed by a member may be performed by one member, an assembly, or a combination of members.

In this application, the terms "up", "down", "left", "right", "front", and "rear" and other directional words are described based on the orientation or positional relationship shown in the drawings, and should not be understood as limitations to the examples of this application. In addition, in this context, it also needs to be understood that when it is mentioned that an element is connected "above" or "under" another element, it can not only be directly connected "above" or "under" the other element, but can also be indirectly connected "above" or "under" the other element through an intermediate element. It should also be understood that orientation words such as upper side, lower side, left side, right side, front side, and rear side do not only represent perfect orientations, but can also be understood as lateral orientations. For example, lower side may include directly below, bottom left, bottom right, front bottom, and rear bottom.

In this application, the terms "controller", "processor", "central processor", "CPU" and "MCU" are interchangeable. Where a unit "controller", "processor", "central processing", "CPU", or "MCU" is used to perform a specific function, the specific function may be implemented by a single aforementioned unit or a plurality of the aforementioned unit.

In this application, the term "device", "module" or "unit" may be implemented in the form of hardware or software to achieve specific functions.

In this application, the terms "computing", "judging", "controlling", "determining", "recognizing" and the like refer to the operations and processes of a computer system or similar electronic computing device (e.g., controller, processor, etc.).

In the present application, a power management module may include a processor. In some examples, the processor is an electronic processor.

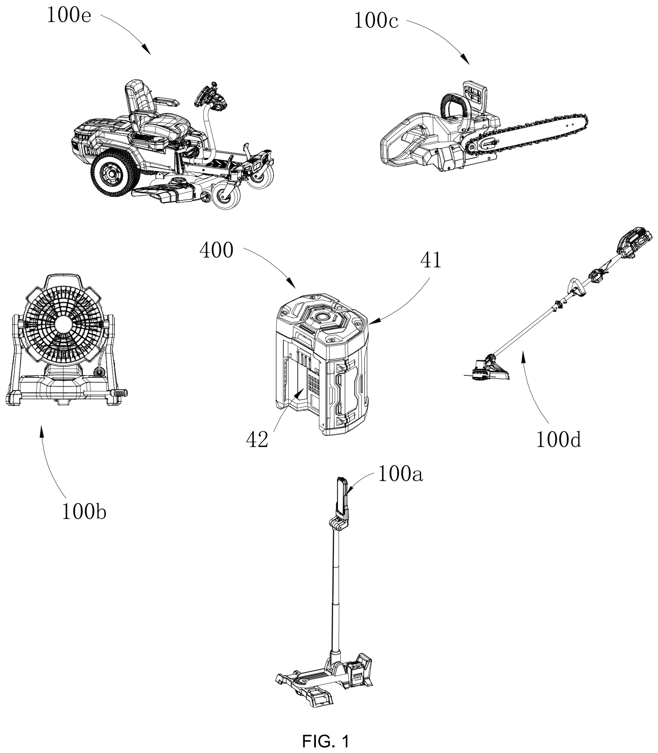

It is to be noted that, referring to FIG. 1, a battery pack 400 provided in the example of the present application may be used for supplying power to power tools or other electrical appliances such as a frame lamp 100a and a fan 100b. The power tools may include, but are not limited to, a chainsaw 100c, handheld devices such as a handheld string trimmer 100d, and outdoor traveling devices such as a manned mower 100e. As long as the power tool adopts the substantial content of the technical solutions disclosed below, the power tool is within the scope of the present application.

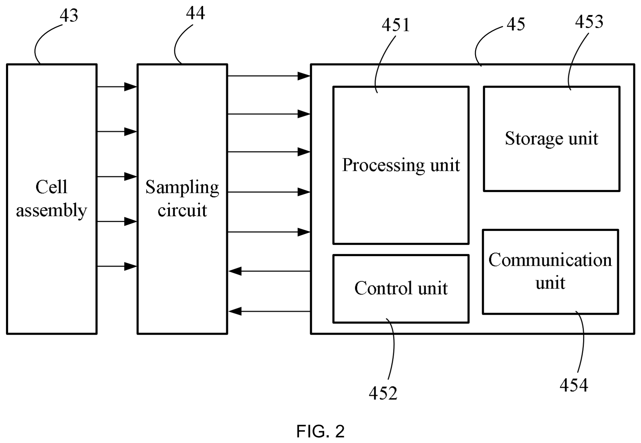

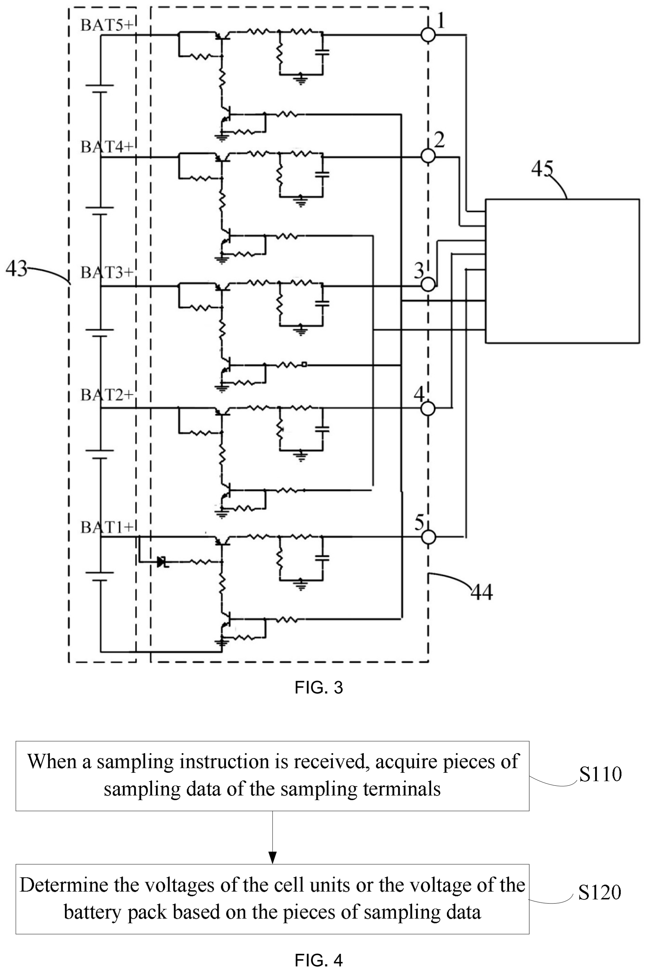

FIG. 1 is a physical view of a battery pack 400 according to an example of the present application. FIG. 2 is a schematic block diagram of a battery pack according to an example of the present application. FIG. 3 is a partial circuit diagram of a battery pack according to an example of the present application. Referring to FIGS. 1 to 3, the battery pack 400 provided in the example of the present application includes a housing 41, a cell assembly 43 disposed within the housing, a sampling circuit 44, a processor 45, and a coupling portion 42. The cell assembly 43 includes n cell units connected in series, where n is an integer greater than 1. The sampling circuit 44 includes n sampling terminals connected to the cell units in one-to-one correspondence, and the sampling terminals can collect sampling data of the corresponding cell units 43. The processor 45 is electrically connected to the sampling circuit 44 and used for monitoring the state of the cell assembly 43. In some examples, the state of the cell assembly 43 includes at least the voltage, state of charge, state of power, or fault information of the cell assembly 43 or each cell unit. The coupling portion 42 is used for connecting a charger or a power tool so that the charger can charge the battery pack or the battery pack can supply power to the power tool. FIG. 3 only exemplarily shows a case where the cell assembly 43 includes five cell units BAT1, BAT2, BAT3, BAT4, and BAT5 and does not limit the number of cell units in the cell assembly 43.

In some examples, the processor 45 includes a processing unit 451, a control unit 452, a storage unit 453, and a communication unit 454. The processing unit 451 is used for receiving sampling data from each sampling terminal and processing each piece of sampling data. The control unit 452 is used for controlling the enable state of each sampling terminal. The storage unit 453 is used for storing at least the voltage of each cell unit and the voltage of the battery pack. The communication unit 454 is used for external communication so that the battery pack can respond to the signal outputted by the load or charger.

In some examples, the battery pack 400 includes a working mode and a fault detection mode. In the working mode, each sampling terminal is enabled, and the processor 45 samples each sampling terminal to determine the voltage of each cell unit. In the fault detection mode, some sampling terminals are enabled, some sampling terminals are disabled, and the processor 45 determines the working state of the sampling circuit 44 according to the sampling data. The working state of the sampling circuit 44 includes a fault state and a normal state.

In some examples, the processor 45 is configured to, when receiving a sampling instruction, sample n sampling terminals to acquire pieces of sampling data and determine the voltages of the cell units or the voltage of the battery pack based on the pieces of sampling data. The sampling time interval t1 between two adjacent samplings has a value range of 10µs ≤ t1 ≤ 50µs. The sampling instruction may be understood as an instruction for sampling the voltage of each cell unit or the voltage of the battery pack. In some examples, sampling instructions are periodically sent to the processor. In some examples, the sampling instruction is a charging instruction or a discharging instruction.

After sampling n sampling terminals and acquiring sampling data, the processor determines the voltage of each cell unit or the voltage of the battery pack based on the sampling data, thereby achieving "synchronous sampling" of the cell units. Compared with the existing method in which sampling and voltage calculation are performed simultaneously and then the next cell unit is sampled, this method can shorten the sampling time of adjacent cell units so that even though the voltage of the cell unit changes periodically, the error value of the finally calculated voltage is greatly reduced, thereby improving the control accuracy of the battery pack. When the sampling instruction is received, n sampling terminals are sampled to acquire the sampling data, and then the voltage of each cell unit or the voltage of the battery pack is determined based on the sampling data so that the sampling time interval t1 between two adjacent samplings can satisfy 10µs ≤ t1 ≤ 50µs. In this manner, the sampling time of the sampling terminals can be greatly shortened, and the error value of the determined voltage is smaller, which is conducive to improving the accuracy of the collected voltage of each cell unit, thereby improving the accuracy of the calculated state of charge and state of power and improving the charging and discharging efficiency and safety performance of the battery pack.

In some examples, the sampling time intervals t1 are the same, that is, the time interval from the completion of sampling of the previous sampling terminal to the start of sampling of the next sampling terminal remains unchanged so that the errors of the finally calculated voltages of the cell units are the same, thereby making the performance parameters of the battery pack calculated based on the voltage more useful for reference.

In some examples, the sampling time intervals t1 are different, that is, the time interval from the completion of sampling of the previous sampling terminal to the start of sampling of the next sampling terminal varies. In this manner, when frequent voltage sampling is required, the sampling time interval t1 can be shortened so that the performance parameters of the battery pack can be updated in a timely manner. When frequent voltage sampling is not required, the sampling time interval t1 can be extended, thereby reducing the energy consumption of the battery management module, which is conducive to saving energy and increasing the power of the battery pack that can be outputted.

It is to be understood that when the battery pack performs charging or discharging, a more accurate sampling voltage is required, so the sampling frequency can be appropriately increased to optimize the charging and discharging effects and prevent the battery pack from being overcharged or over-discharged. When the battery pack is at rest, for example, when the battery pack is performing fault/abnormality diagnosis or calculating the state of charge, the sampling frequency can be appropriately reduced to reduce the energy consumption of the battery pack.

In some examples, when the battery pack performs charging or discharging, the time interval t2 between two adjacent moments when the sampling instruction is received has a value range of 40ms ≤ t2 ≤ 50ms.

In some examples, when the battery pack is at rest, the time interval t3 between two adjacent moments when the sampling instruction is received has a value range of 50ms ≤ t3 ≤ 70ms.

In some examples, the cell units are a first cell unit, a second cell unit, ..., and an n-th cell unit, respectively. The first cell unit, the second cell unit, ..., and the n-th cell unit are connected in series in sequence. The sampling terminal electrically connected to the first cell unit is the first sampling terminal 1, the sampling terminal electrically connected to the second cell unit is the second sampling terminal 2, ..., and the sampling terminal electrically connected to the n-th cell unit is the n-th sampling terminal n. The sampling data sampled at the first sampling terminal 1 is the first sampling data, the sampling data sampled at the second sampling terminal 2 is the second sampling data, ..., and the sampling data sampled at the n-th sampling terminal n is the n-th sampling data. The processor is configured to calculate the voltage of the first cell unit based on the first sampling data and calculate the voltage of the i-th cell unit based on the (i-1)-th sampling data and the i-th sampling data. 2 ≤ i ≤ n, and i is an integer.

Referring to FIG. 3, the battery pack 400 includes five cell units connected in series, which are the first cell unit BAT1, the second cell unit BAT2, the third cell unit BAT3, the fourth cell unit BAT4, and the fifth cell unit BAT5. The cell units are connected to the processor 45 via the sampling circuit 44. The sampling circuit 44 includes a sampling terminal 1, a sampling terminal 2, a sampling terminal 3, a sampling terminal 4, and a sampling terminal 5. The processor 45 calculates the voltage of the first cell unit according to the first sampling data of the first sampling terminal 1 connected to the first cell unit. The voltage of the second cell unit is calculated based on the first sampling data and the second sampling data, the voltage of the third cell unit is calculated based on the second sampling data and the third sampling data, the voltage of the fourth cell unit is calculated based on the third sampling data and the fourth sampling data, and the voltage of the fifth cell unit is calculated based on the fourth sampling data and the fifth sampling data. Since the present application adopts the method of sampling the cell units and then calculating, the sampling time of adjacent cell units is greatly shortened so that when the voltage of the current cell unit is calculated according to the sampling data of the previous cell unit and the sampling data of the current cell unit, the calculation error can be greatly reduced, which is conducive to improving the accuracy of the calculation results.

In some examples, the processor 45 is configured to determine whether the voltage of each cell unit is abnormal and when the voltage of at least one cell unit is abnormal, output a first abnormal signal to indicate a fault. The abnormal voltage may include, but is not limited to, the voltage of the cell unit being greater than the maximum allowable voltage or less than the minimum allowable voltage or the differences between the voltage of the cell unit and the voltages of other cell units being too large. The first abnormal signal may include, but is not limited to, at least one of a text prompt signal, a sound prompt signal, or a light prompt signal. Specifically, after the voltage of each cell unit is obtained, whether the voltage of each cell unit is abnormal is determined. When the voltages of all the cell units are normal, it is determined that the battery pack is in the normal state. On the contrary, when the voltage of the cell unit is abnormal, it indicates that the battery pack has a fault, so the first abnormal signal is outputted to indicate the fault, thereby reminding the user to be aware of the fault and handle the fault in a timely manner.

In some examples, the processor is configured to output electrical energy of the battery pack to an external device when no abnormal voltage exists. The external device includes at least one of a power tool, a charger, or an adapter. Specifically, when no abnormal voltage exists, that is, the voltages of all the cell units are normal, it indicates that the battery pack is in the normal state and can supply electrical power to the external device, thereby supplying power to the external device.

Based on the same inventive concept, the present application further provides a method for monitoring the voltage of each cell unit in a battery pack. FIG. 4 is a flowchart of a method for monitoring the voltage of each cell unit in a battery pack according to an example of the present application. Referring to FIG. 4, the method includes the steps below.

In S110, when a sampling instruction is received, pieces of sampling data of the sampling terminals are acquired.

The battery pack includes a cell assembly, a sampling circuit, and a processor. The cell assembly includes n cell units connected in series. The sampling circuit includes n sampling terminals in one-to-one correspondence with the cell units. The processor is used for monitoring the state of the cell assembly. In some examples, the battery pack is used for supplying power to a power tool, or the battery pack is used for connecting a charger for charging. In some examples, the battery pack includes a mobile power supply.

The sampling instruction may be understood as an instruction for sampling the voltage of each cell unit or the voltage of the battery pack.

In S120, based on the pieces of sampling data, the voltages of the cell units are determined or the voltage of the battery pack is determined.

In this example, when the sampling instruction is received, sampling data of each sampling terminal is acquired, and then the voltage of each cell unit or the voltage of the battery pack is determined based on the sampling data so that after pieces of sampling data are collected, the pieces of sampling data are processed to obtain the voltages of the cell units. In this manner, the sampling time of the sampling terminals can be greatly shortened, and the error value of the determined voltage is smaller, which is conducive to improving the accuracy of the collected voltage of each cell unit, thereby improving the accuracy of the calculated state of charge and state of power and improving the charging and discharging efficiency and safety performance of the battery pack.

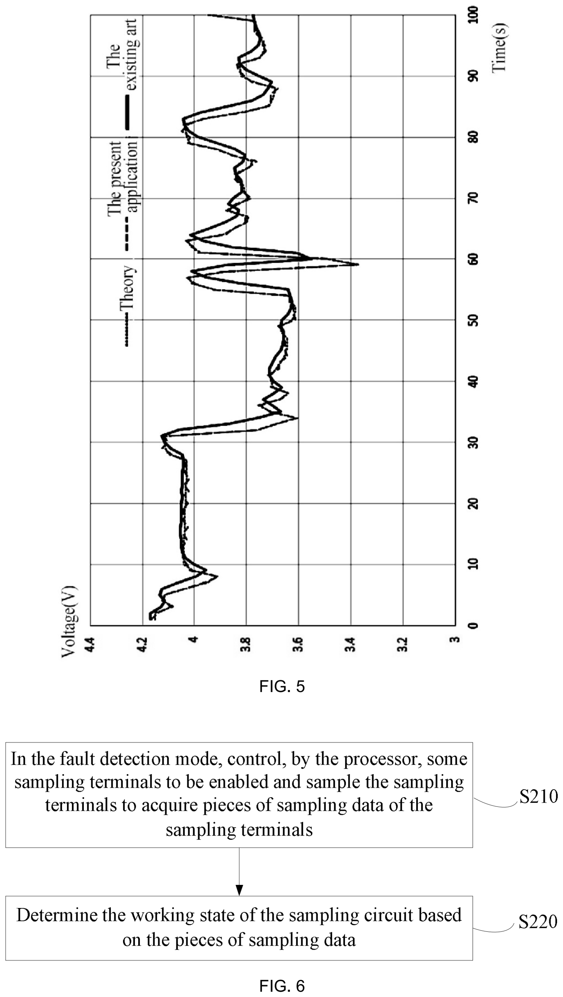

FIG. 5 is a comparison diagram of voltage sampling data according to an example of the present application. Referring to FIG. 5, it can be seen that the voltage of the battery pack determined in the present application basically coincides with the theoretical value, while the voltage of the battery pack determined in the existing art lags behind the theoretical value.

Based on the same inventive concept, the present application further provides a charging system. The charging system includes a battery management module and at least one of a battery pack, a charger, or a power tool. The battery pack is used for receiving or outputting electrical energy. The battery pack includes n cell units connected in series and a sampling circuit. The sampling circuit includes n sampling terminals in one-to-one correspondence with the cell units. The charger is used for supplying electrical energy to the battery pack. The power tool is used for receiving the electrical energy outputted by the battery pack. The battery management module is used for monitoring the state of the battery pack.

In some examples, the battery management module is configured to acquire pieces of sampling data from all the sampling terminals and determine the voltages of the cell units and the voltage of the battery pack based on all the pieces of sampling data.

The charging system provided in the example of the present application includes the preceding battery pack and has corresponding beneficial effects. For the similarities, reference may be made to the preceding description.

In some examples, the present application provides the battery pack 400. The battery pack 400 includes the housing 41, the cell assembly 43 disposed within the housing 41, the sampling circuit 44, the processor 45, and the coupling portion 42. The cell assembly 43 includes n cell units, which are the first cell unit, the second cell unit, ..., and the n-th cell unit that are connected in series in sequence. The sampling circuit 44 includes n sampling terminals. The sampling terminal electrically connected to the first cell unit is the first sampling terminal 1, the sampling terminal electrically connected to the second cell unit is the second sampling terminal 2, ..., and the sampling terminal electrically connected to the n-th cell unit is the n-th sampling terminal n. The processor 45 is electrically connected to the sampling circuit 44 and used for monitoring the state of the cell assembly 43.

In some examples, the processor 45 is configured to, in the fault detection mode, sample n sampling terminals to acquire pieces of sampling data of the sampling terminals and determine the working state of the sampling circuit based on the pieces of sampling data.

The fault detection mode includes a first detection sub-mode and a second detection sub-mode. In the first detection sub-mode, even-numbered sampling terminals are enabled, and odd-numbered sampling terminals are disabled. In the second detection sub-mode, odd-numbered sampling terminals are enabled, and even-numbered sampling terminals are disabled. The working state includes at least the fault state and the normal state.

It is to be understood that in the first detection sub-mode, even-numbered sampling terminals are enabled and odd-numbered sampling terminals are disabled; and in the second detection sub-mode, odd-numbered sampling terminals are enabled and even-numbered sampling terminals are disabled. Since the disabled sampling terminal cannot collect the voltage data of the corresponding cell unit, the sampling data of the disabled sampling terminal should be close to 0. In this case, if the sampling data of the disabled sampling terminal is greater than 0, it indicates that a short circuit exists between this sampling terminal and the adjacent sampling terminal.

In this example, the fault detection mode includes the first detection sub-mode and the second detection sub-mode. In the first detection sub-mode, even-numbered sampling terminals are enabled, and odd-numbered sampling terminals are disabled. In the second detection sub-mode, odd-numbered sampling terminals are enabled, and even-numbered sampling terminals are disabled. In this manner, in the fault detection mode, the enable states of any two adjacent sampling terminals are different so that after the sampling terminals are sampled to obtain pieces of sampling data, the state of the sampling circuit can be determined based on the pieces of sampling data. In this manner, the fault in the sampling circuit can be identified quickly and accurately and the fault position can be located quickly and accurately, thereby avoiding measuring erroneous voltage values.

In some examples, the processor 45 is configured to, in the first detection sub-mode, when the sampling data of an odd-numbered sampling terminal is greater than or equal to a first data threshold, determine that the sampling data is abnormal and determine that the working state of the sampling circuit is an abnormal state.

In some examples, the processor 45 is configured to, in the second detection sub-mode, when the sampling data of an even-numbered sampling terminal is greater than or equal to a second data threshold, determine that the sampling data is abnormal and determine that the working state of the sampling circuit is the abnormal state.

The abnormal state includes a short circuit fault or an open circuit fault between the sampling terminal corresponding to the abnormal sampling data and the adjacent sampling terminal.

The first data threshold and/or the second data threshold may be determined according to characteristics of the sampling circuit. It is to be understood that when the sampling terminal is disabled, the voltage data of the corresponding cell unit cannot be collected. Therefore, ideally, the sampling data of the disabled sampling terminal should be 0. However, due to the inevitable interference between the various components in the sampling circuit, the sampling data of the disabled sampling terminal may not be zero. Therefore, by setting the first data threshold and the second data threshold, interference between components is eliminated, thereby preventing the sampling circuit in the normal state from being misjudged as the sampling circuit in the abnormal state, which is conducive to improving the accuracy of the determined working state of the sampling circuit.

In some examples, the first data threshold and the second data threshold are equal. In other examples, the first data threshold and the second data threshold are different. The relationship between the first data threshold and the second data threshold is not specifically limited in this example, as long as the core inventive concept of the present application can be achieved.

In some examples, the processor 45 is configured to periodically control the battery pack to be in the working mode and the fault detection mode, that is, during the operation of the battery pack, the battery pack is periodically in the fault detection mode so that when an abnormality occurs in the sampling circuit of the battery pack, the fault can be discovered in a timely manner, thereby improving the control accuracy of the battery pack.

In some examples, periodically controlling the battery pack to be in the working mode and the fault detection mode includes: controlling the battery pack to be in the fault detection mode at intervals of a preset time period, and exiting the fault detection mode to enter the working mode when the detection is completed.

In some examples, periodically controlling the battery pack to be in the working mode and the fault detection mode includes: controlling the battery pack to be in the fault detection mode when the voltage change reaches a preset value, and exiting the fault detection mode to enter the working mode when the detection is completed.

It is to be understood that in the first detection sub-mode or the second detection sub-mode, if the sampling data of the disabled sampling terminal is greater than 0, it indicates that a short circuit exists between this sampling terminal and the adjacent sampling terminal. It can be seen that, by only using one of the first detection sub-mode and the second detection sub-mode, it is impossible to determine which one of the adjacent sampling terminals is short-circuited to the sampling terminal with sampling data greater than 0. Therefore, in some examples, the processor is configured such that the detection sub-modes are different in the fault detection mode of two adjacent cycles. In this manner, if the disabled sampling terminal with sampling data greater than 0 exists in the previous cycle, this sampling terminal is defined as sampling terminal a, and the sampling terminals adjacent to sampling terminal a are sampling terminal b and sampling terminal c. Since the detection sub-mode of the current cycle is different from that of the previous cycle, in the current cycle, sampling terminal a is enabled, while sampling terminal b and sampling terminal c are disabled. In this case, whether the sampling data of sampling terminal b is greater than the data threshold and whether the sampling data of sampling terminal c is greater than the data threshold are determined. If the sampling data of sampling terminal b is greater than the data threshold, and the sampling data of sampling terminal c is less than the data threshold, it indicates that a short circuit exists between sampling terminal a and sampling terminal b. On the contrary, if the sampling data of sampling terminal c is greater than the data threshold, and the sampling data of sampling terminal b is less than the data threshold, it indicates that a short circuit exists between sampling terminal a and sampling terminal c. In addition, if the sampling data of sampling terminal b and the sampling data of sampling terminal c are both less than the data threshold, it indicates that a short circuit exists between any two of sampling terminal a, sampling terminal b, and sampling terminal c.

In some examples, the processor 45 is configured to, within the same fault detection mode cycle, first control the battery pack to be in the first detection sub-mode, and after the first detection sub-mode ends, control the battery pack to be in the second detection sub-mode. Alternatively, the processor 45 is configured to, within the same fault detection mode cycle, first control the battery pack to be in the second detection sub-mode, and after the second detection sub-mode ends, control the battery pack to be in the first detection sub-mode. In this manner, the position where the sampling circuit fails can be determined more specifically within the same fault detection mode cycle, thereby further improving the reliability of the detected battery pack voltage.

In some examples, the processor 45 is further configured to, when the working state of the sampling circuit is abnormal, output a second abnormal signal to indicate a fault, thereby reminding the user to be aware of the fault and handle the fault of the sampling circuit in a timely manner.

Based on the same inventive concept, the present application further provides a method for identifying a fault of a battery pack. FIG. 6 is a flowchart of a method for identifying a fault of a battery pack according to an example of the present application. Referring to FIG. 6, the method includes the steps below.

In S210, in the fault detection mode, the processor controls some sampling terminals to be enabled and samples the sampling terminals to acquire pieces of sampling data of the sampling terminals.

In S220, the working state of the sampling circuit is determined based on the pieces of sampling data.

The working state includes at least the fault state and the normal state.

In this example, in the fault detection mode, the processor controls some sampling terminals to be enabled, controls the remaining sampling terminals to be disabled, and samples the sampling terminals to acquire pieces of sampling data of the sampling terminals, thereby determining the state of the sampling circuit based on the pieces of sampling data. In this manner, the fault in the sampling circuit can be identified quickly and accurately and the fault position can be located quickly and accurately, thereby avoiding measuring erroneous voltage values.

The basic principles, main features, and advantages of this application are shown and described above. It is to be understood by those skilled in the art that the aforementioned examples do not limit the present application in any form, and all technical solutions obtained through equivalent substitutions or equivalent transformations fall within the scope of the present application.

## Claims

1. A battery pack (400), comprising:
a housing (41);
a cell assembly (43) disposed within the housing and comprising n cell units connected in series, wherein n > 1, and n is an integer;
a sampling circuit (44) comprising n sampling terminals connected to the n cell units in one-to-one correspondence; and
a processor (45) electrically connected to the sampling circuit and used for monitoring a state of the cell assembly;
wherein the processor is configured to, when receiving a sampling instruction, sample the n sampling terminals to acquire pieces of sampling data and determine voltages of the n cell units or a voltage of the battery pack based on the pieces of sampling data, wherein a sampling time interval t1 between two adjacent samplings has a value range of 10µs ≤ t1 ≤ 50us.

2. The battery pack of claim 1, wherein the n cell units are a first cell unit, a second cell unit, ..., and an n-th cell unit that are connected in series in sequence; a sampling terminal electrically connected to the first cell unit is a first sampling terminal, a sampling terminal electrically connected to the second cell unit is a second sampling terminal, ..., and a sampling terminal electrically connected to the n-th cell unit is an n-th sampling terminal; sampling data sampled at the first sampling terminal is first sampling data, sampling data sampled at the second sampling terminal is second sampling data, ..., and sampling data sampled at the n-th sampling terminal is n-th sampling data; and the processor is configured to calculate a voltage of the first cell unit based on the first sampling data and calculate a voltage of an i-th cell unit based on (i-1)-th sampling data and i-th sampling data, wherein 2 ≤ i ≤ n, and i is an integer.

3. The battery pack of claim 1, wherein the processor is configured to determine whether a voltage of each of the n cell units is abnormal and when a voltage of at least one of the n cell units is abnormal, output a first abnormal signal to indicate a fault.

4. The battery pack of claim 3, wherein the processor is configured to output electrical energy of the battery pack to an external device when no abnormal voltage exists, and the external device comprises at least one of a power tool, a charger, or an adapter.

5. The battery pack of claim 1, wherein the state of the cell assembly comprises at least a voltage, a state of charge, a state of power, or fault information of the cell assembly or each of the n cell units.

6. The battery pack of claim 1, wherein sampling time intervals t1 are the same.

7. The battery pack of claim 1, wherein sampling time intervals t1 have different values.

8. The battery pack of claim 1, wherein when the battery pack performs charging or discharging, a time interval t2 between two adjacent moments when the sampling instruction is received has a value range of 40ms ≤ t2 ≤ 50ms.

9. The battery pack of claim 1, wherein when the battery pack is at rest, a time interval t3 between two adjacent moments when the sampling instruction is received has a value range of 50ms ≤ t3 ≤ 70ms.

10. A method for monitoring a voltage of each cell unit in a battery pack (400), wherein the battery pack comprises a cell assembly (43), a sampling circuit (44), and a processor (45); the cell assembly comprises n cell units connected in series; the sampling circuit comprises n sampling terminals in one-to-one correspondence with the n cell units; the processor is used for monitoring a state of the cell assembly; and the method comprises:
when a sampling instruction is received, acquiring pieces of sampling data of the n sampling terminals; and
determining voltages of the n cell units or a voltage of the battery pack based on the pieces of sampling data.

11. The method for monitoring a voltage of each cell unit in a battery pack of claim 10, wherein the battery pack is used for supplying power to a power tool, or the battery pack is used for connecting a charger for charging.

12. The method for monitoring a voltage of each cell unit in a battery pack of claim 10, wherein the battery pack comprises a mobile power supply.
